Europäisches Patentamt

European Patent Office

Office européen des brevets

(11) Veröffentlichungsnummer: **0 464 869 A1**

# EUROPÄISCHE PATENTANMELDUNG

(21) Anmeldenummer: **91114945.8**

(22) Anmeldetag: **17.12.85**

(51) Int. Cl.5: **G02B 6/12**

Diese Anmeldung is am 04 - 09 - 1991 als Teilanmeldung zu der unter INID-Kode 60 erwähnten Anmeldung eingereicht worden.

(30) Priorität: **07.01.85 DE 3500306**

(43) Veröffentlichungstag der Anmeldung:
**08.01.92 Patentblatt 92/02**

(60) Veröffentlichungsnummer der früheren Anmeldung nach Art. 76 EPÜ: **0 187 979**

(84) Benannte Vertragsstaaten:
**AT BE CH DE FR GB IT LI LU NL SE**

(71) Anmelder: **Siemens Aktiengesellschaft**
**Wittelsbacherplatz 2**
**W-8000 München 22(DE)**

(72) Erfinder: **Heinen, Jochen, Dr.**
**Dianastrasse 38**
**W-8013 Haar(DE)**
Erfinder: **Mahlein, Hans F., Dr.**
**Oueristrasse 2**
**W-8025 Unterhaching(DE)**
Erfinder: **März, Reinhard, Dr.**
**Hofangerstrasse 79**
**W-8000 München 83(DE)**
Erfinder: **Plihal, Manfred, Dr.**
**Sonnenspitzstrasse 13**
**W-8000 München 82(DE)**
Erfinder: **Schlötterer, Heinrich, Dr.**
**A.-Wagner-Strasse 11a**
**W-8011 Putzbrunn(DE)**
Erfinder: **Winzer, Gerhard, Dr.**
**Zugspitzstrasse 10**
**W-8011 Putzbrunn(DE)**
Erfinder: **Wolff, Ulrich, Dipl.-Phys.**
**Geigenbergerstrasse 35**
**W-8000 München 71(DE)**

(54) **Monolithisch integrierter WDM-Demultiplexmodul und ein Verfahren zur Herstellung eines solchen Moduls.**

(57) Monolithisch integrierter WDM-Demultiplexmodul, bei dem auf einem Substrat (1) aus InP ein Schichtwellenleiter (10) aus InGaAsP ausgebildet ist, auf den eine Fotodiode (31) aus InGaAs aufgebracht ist. Die Fotodiode (31) ist durch Leckwellenkopplung an den Schichtwellenleiter (10) optisch gekoppelt. In der Oberfläche des Schichtwellenleiters (10) ist ein wellenlängenselektierendes Element (20) in Form eines Gitters ausgebildet. Der Modul kann mit einem einzigen Epitaxieschritt hergestellt werden. Es werden auch Maßnahmen zur Erhöhung der Nebensprechdämpfung des Moduls angegeben sowie eine Maßnahme zur besseren Einkopplung von Strahlung in den Modul.

FIG 2

Die vorliegende Erfindung betrifft einen monolithisch integrierten WDM-Demultiplexmodul nach dem Oberbegriff des Patentanspruchs 1 und ein Verfahren zur Herstellung eines solchen Moduls.

Ein Modul der genannten Art und ein Verfahren zu seiner Herstellung sind beispielsweise aus 'Appl. Physics Letters', Vol.40, No.2, 15 January 1982, S.120-122 bekannt. Bei diesem bekannten Modul besteht das Substrat aus Silizium und der Schichtwellenleiter aus $As_2S_3$. Zwischen dem Schichtwellenleiter und dem Substrat ist eine Pufferschicht aus $SiO_2$ angeordnet. Das wellenlängenselektierende Element besteht aus einem in die Oberfläche des Lichtwellenleiters eingebrachten Gitter, dessen Rillen schräg zur Ausbreitungsrichtung der im Schichtwellenleiter sich ausbreitenden Strahlung verlaufen. Die hinter einem Gitter sich in verschiedenen Richtungen im Schichtwellenleiter ausbreitenden und untereinander verschiedene Wellenlängen enthaltenden Strahlungsanteile werden verschiedenen Fotodetektoren in Form von Fotodioden zugeführt. Auf diese Weise definiert jeder dieser Strahlungsanteile, dem eine eigene Wellenlänge zugeordnet ist, einen Wellenlängenkanal und jedem dieser Kanäle ist ein eigener Fotodetektor zugeordnet.

Die Herstellung des Moduls erfolgt so, daß zunächst auf der Oberfläche des Siliziumsubstrats thermisch die Pufferschicht erzeugt und dann der Schichtwellenleiter durch Aufdampfen im Vakuum erzeugt wird. Die Fotodioden werden in Form von Schottky-Dioden ausgebildet. Das wellenlängenselektierende Gitter wird mittels Elektronenstrahl in die Oberfläche des Schichtwellenleiters eingeschrieben.

Die vorliegende Erfindung zielt ab auf die kostengünstige und gut reproduzierbare Herstellung monolithisch integrierter WDM-Demultiplexmodule mit guten Demultiplexeigenschaften.

Diese Aufgabe wird ausgehend von einem Modul der eingangs genannten Art durch die im kennzeichnenden Teil des Patentanspruchs 1 angegebenen Merkmale gelöst, nach denen das Substrat aus InP und der Schichtwellenleiter aus einer quaternären Schicht besteht.

Die quaternäre Schicht besteht vorzugsweise gemäß Anspruch 2 aus InGaAsP.

Vorteilhafterweise ist gemäß Anspruch 3 ein Fotodetektor durch Leckwellenkopplung an den Schichtwellenleiter optisch gekoppelt.

Der erfindungsgemäße Modul läßt sich besonders einfach herstellen, wenn gemäß Anspruch 4 der durch Leckwellenkopplung an den Schichtwellenleiter optisch gekoppelte Fotodetektor einen P-N-Übergang in einer oder mehreren unmittelbar auf den Schichtwellenleiter aufgebrachten ternären Schichten aufweist. Ein derartiger Modul läßt sich mit nur einem Epitaxieschritt, d.h. in einem einheitlichen epitaktischen Prozeß, bei dem eine oder mehrere Schichten in unmittelbarer Aufeinanderfolge aufgewachsen werden, herstellen.

Vorzugsweise besteht gemäß Anspruch 5 eine ternäre Schicht aus InGaAs, insbesondere dann, wenn die quaternäre Schicht gemäß Anspruch 2 aus InGaAsP besteht.

Bei einem erfindungsgemäßen Modul nach einem der Ansprüche 3 bis 5 läßt sich die Leckwellenkopplung auf einfache Weise dadurch verbessern, daß gemäß Anspruch 6 bei dem durch Leckwellenkopplung an den Schichtwellenleiter optisch gekoppelten Fotodetektor ein quer zum Schichtwellenleiter sich erstreckendes und schräg zur Ausbreitungsrichtung des von diesem Fotodetektor empfangenen Strahlungsanteiles angeordnetes reflektierendes Element vorgesehen ist, das die am Fotodetektor vorbeigehende Strahlung in Richtung zum Fotodetektor reflektiert und/daß der Schichtwellenleiter im Bereich dieses Fotodetektors eine Verjüngung aufweist.

Der einem Fotodetektor zugeführte Strahlungsanteil kann kanalfremde und damit störende Wellenlängen enthalten. Bei einem Modul gemäß Anspruch 6 kann der Einfluß einer derartigen störenden Wellenlänge auf einfache Weise gemäß Anspruch 7 dadurch vermindert werden, daß das reflektierende Element ein Filter zur Ausfilterung der störenden Wellenlänge aufweist.

Ein erfindungsgemäßer Modul wird zweckmäßigerweise gemäß Anspruch 8 mit einer Deckschicht abgedeckt, die insbesondere bei Modulen nach den Ansprüchen 3, 4, 5, 6 oder 7 und 8 vorzugsweise gemäß Anspruch 9 aus $Si_3N_4$, Polyimid oder InP besteht.

Bei einem monolithisch integrierten Modul der eingangs genannten Art und damit auch bei einem erfindungsgemäßen Modul nach einem der Ansprüche 1 bis 9 tritt Nebensprechen auf, das zum Teil optisch und zum Teil elektrisch bedingt ist. Dieses Nebensprechen kann bei einem Modul der eingangs genannten Art und insbesondere bei einem erfindungsgemäßen Modul auf einfache Weise dadurch gedämpft werden, daß gemäßO Anspruch 10 das wellenlängenselektierende Element so ausgebildet ist, daß die verschiedenen Richtungen, in denen sich zwei benachbarte aufgespaltene Strahlungsanteile im Schichtwellenleiter ausbreiten, einen Winkel zwischen sich einschließen, der größer als 90° ist, und/oder daß zwischen benachbarten Strahlungsanteilen und Fotodetektoren eine Furche und/oder ein Erdungskontakt ausgebildet ist. Der größere Winkel zwischen benachbarten Strahlungsanteilen führt dazu, daß sich diese Strahlungsanteile weniger gegenseitig beeinflussen und daß die Fotodetektoren in einem größeren Abstand voneinander angeordnet sind und sich dadurch ebenfalls weniger gegenseitig beeinflussen. Entsprechend wirkt eine Furche zwischen benachbarten Strahlungsanteilen und ein Erdungskontakt zwischen benachbarten Fotodetektoren. Am günstigsten für eine hohe Nebensprechdämpfung ist es, alle diese Maßnahmen gleichzeitig zu realisieren.

Das wellenlängenselektierende Element, das so ausgebildet ist, daß die verschiedenen Richtungen, in denen sich zwei benachbarte aufgespaltene Strahlungsanteile im Schichtwellenleiter ausbreiten, einen Winkel zwischen einschließen, der größer als 90° ist, kann auf einfache Weise dadurch realisiert werden, daß dieses Element gemäß Anspruch 11 aus einem Gitter besteht, dessen Furchen steiler als 45° zu der bestimmten Richtung verlaufen, in der sich die auf das Gitter treffende Strahlung ausbreitet.

Eine bessere Einkopplung in einen monolithisch integrierten Demultiplexmodul der eingangs genannten Art und insbesondere in einen erfindungsgemäßen Modul kann auf einfache Weise dadurch erreicht werden, daß gemäß Anspruch 12 der Schichtwellenleiter eine Verdickung aufweist, die einen Streifenwellenleiter definiert, über den Strahlung in den Schichtwellenleiter einkoppelbar ist. Die einzukoppelnde Strahlung ist meist die aus einer Faser, insbesondere die aus einer Monomode-Faser austretende Strahlung. Der Schichtwellenleiter ist im Bereich der Verdickung dem Faserquerschnitt besser angepaßt, wodurch die Einkopplung verbessert wird.

Die Verdickung des Schichtwellenleiters wird zweckmäßigerweise gemäß Anspruch 13 durch einen parallel zum Schichtwellenleiter verlaufenden vergrabenen Streifenwellenleiter realisiert, der sich in das Substrat erstreckt.

Ein vorteilhaftes Verfahren zur Herstellung eines erfindungsgemäßes Moduls ist im Anspruch 14 angegeben.

Die Erfindung wird in der folgenden Beschreibung anhand der Figuren beispielhaft erläutert. Von den Figuren zeigen:

Fig.1    eine Draufsicht auf einen schematisch dargestellten monolithisch integrierten WDM-Demultiplexmodul,

Fig.2    einen Schnitt durch den Modul nach Fig.1 längs der Schnittlinie II-II,

Fig.3    in der gleichen Schnittdarstellung wie in Fig.2 eine modifizierte Ausführungsform des Moduls nach Fig.1,

Fig.4    einen Ausschnitt aus einer Schnittdarstellung gemäß Fig.2, aus der die Ausführung eines reflektierenden Elementes bei dem Fotodetektor hervorgeht,

Fig.5 und 6    Ausschnitte gemäß Fig.4, die anstelle eines reflektierenden Elementes bei dem Fotodetektor verschiedene Ausführungen von Verjüngungen des Schichtwellenleiters im Bereich des Fotodetektors zeigen,

Fig.7    eine Draufsicht gemäß Fig.1 auf eine modifizierte Ausführungsform eines Moduls, bei dem Maßnahmen zur Erhöhung der Nebensprechdämpfung vorgesehen sind, und

Fig.8    einen Ausschnitt auf eine Stirnansicht eines Moduls, die eine Verdickung des Schichtwellenleiters zeigt, wobei die Stirnansicht einer Draufsicht auf die linke Seite in Richtung 12 des in Fig.1 dargestellten Moduls entspricht.

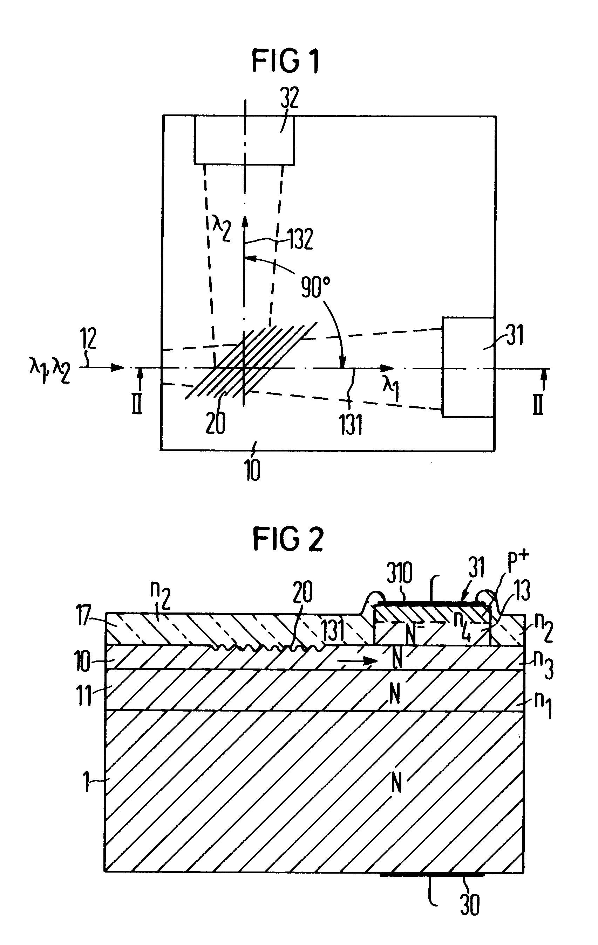

In der Fig.1 ist mit 10 ein Monomode-Schichtwellenleiter auf InP-Basis bezeichnet, in dem sich ein eindimensionaler Gauß'scher Strahl ausbreiten kann. In dem Schichtwellenleiter ist ein ebenes Gitter 20 ausgebildet, das beispielsweise durch Einschreiben mittels Elektronenstrahls hergestellt werden kann.

Das Gitter 20 ist so bemessen und angeordnet, daß eine zwei Wellenlängen $\lambda_1$ und $\lambda_2$ enthaltende Strahlung, die beispielsweise aus einer Monomode-Faser aus der bestimmten Richtung 12 in den Schichtwellenleiter 10 eingekoppelt wird und sich darin im wesentlichen in dieser bestimmten Richtung 12 ausbreitet, am Gitter 20 in zwei Strahlungsanteile aufspaltet, von denen der eine im wesentlichen nur noch die Wellenlänge $\lambda_1$, der andere dagegen im wesentlichen nur noch die andere Wellenlänge $\lambda_2$ enthält, und die sich in verschiedenen Richtungen 131 bzw. 132 im Schichtwellenleiter 10 ausbreiten. In der Fig.1 ist angenommen, daß die beiden Richtungen 131 und 132 einen Winkel von 90° zwischen sich einschließen und daß die Richtung 131 der bestimmten Richtung 12 entspricht.

Auf den Schichtwellenleiter 10 sind Fotodetektoren 31 und 32 aufgebracht, von denen der Detektor 31 den die Wellenlänge $\lambda_1$ enthaltenden Strahlungsanteil und der Detektor 32 den die Wellenlänge $\lambda_2$ enthaltenden Strahlungsanteil empfängt. Die beiden Fotodetektoren 31 und 32 bestehen aus Fotodioden, die durch Leckwellenkopplung an den Schichtwellenleiter 10 gekoppelt sind.

Typische Abmessungen des Moduls nach Fig.1 sind: Die in der Richtung 12 gemessene Länge beträgt wie seine senkrecht zur Richtung 12 gemessene Breite etwa 2 mm. Bei diesen Abmessungen liegen die Längs- und Querabmessungen der Detektoren etwa bei 100 μm.

Der innere Aufbau des Moduls nach Fig.1 geht aus der Schnittansicht nach Fig.2 hervor. Die Schicht 11 ist auf einem Substrat 1 aus InP aufgebracht, die epitaktisch aufgewachsen ist und nur dazu dient, die Oberfläche des Substrats 1 zu verbessern. Die Schicht 11 erübrigt sich, wenn das Substrat 1 bereits eine ausreichende Oberflächengüte aufweist.

Auf die Schicht 11 ist epitaktisch eine $In_{1-x}Ga_xAs_yP_{1-x}$ aufgewachsen, die eine Dicke von höchstens 2 $\mu$m aufweist und die den Schichtwellenleiter bildet.

Das Substrat 1, die Schicht 11 und der Schichtwellenleiter 10 sind N-dotiert und leitend.

In die Oberfläche der Schicht 10 ist das Gitter 20 eingebracht, dessen Furchen in einer zur Zeichenebene senkrechten Ebene schräg zur Zeichenebene verlaufen.

Die Fotodiode 31 ist durch ein Stück einer $In_{0,53}Ga_{0,47}As$-Schicht 13 realisiert, die einen an die Schicht 10 angrenzenden Schichtbereich aufweist, der $N^-$-dotiert oder eigenleitend ist, und an den auf der von der Schicht 10 abgekehrten Seite ein $P^+$-dotierter Bereich angrenzt. Auf der Schicht 13 ist ein P-Kontakt 310 aufgebracht, dessen Gegenkontakt auf der gegenüberliegenden Seite des Substrats 1 als N-Kontakt 30 aufgebracht ist.

Die Schichtdicke des Schichtstückes 13 beträgt typischerweise 1 bis 3 $\mu$m. Die in der Richtung 131 gemessene Länge des Schichtstückes 13 beträgt typischerweise 10 bis 100 $\mu$m, während ihre senkrecht zur Richtung 131 gemessene Breite typischerweise bei 100 $\mu$m liegt.

Das Schichtstück 13 kann aus einer einzigen epitaktisch aufgewachsenen Schicht bestehen, in die der $P^+$-dotierte Bereich durch Diffusion eingebracht ist, oder es kann aus einer epitaktisch aufgewachsenen $N^-$-dotierten oder eigenleitenden Schicht und aus einer darauf epitaktisch aufgewachsenen $P^+$-dotierten Schicht bestehen.

Sämtliche epitaktischen Schichten können durch Flüssigphasenepitaxie aufgewachsen werden.

Die Oberfläche des Moduls ist mit einer Deckschicht 17 abgedeckt, die aus $Si_3N_4$, Polyimid oder InP bestehen kann. Diese Materialien haben einen Brechungsindex $n_2$, der wie der Brechungsindex $n_1$ von InP kleiner ist wie der Brechungsindex $N_3$ der Schicht 10 aus InGaAsP. Dies ist notwendig, damit die Schicht 10 als Schichtwellenleiter wirken kann.

Das Schichtstück 13 aus InGaAs hat einen Brechungsindex $n_4$, der größer ist als der Brechungsindex $n_3$. Dies ist für die Realisierung einer Leckwellenkopplung notwendig.

Der Modul nach den Fig.1 und 2 kann mit nur einem einzigen Epitaxieschritt sehr einfach hergestellt werden. Dazu wird zunächst auf dem leitenden Substrat in einem einzigen Epitaxieschritt eine Schichtenfolge erzeugt, die den Schichten 11, 10 und 13 entspricht. Wie schon erwähnt, kann die dem Schichtstück 13 entsprechende Schicht aus einer einfachen Schicht oder aus einer Doppelschicht bestehen. Diese oberste einfache Schicht oder Doppelschicht wird bis auf das Schichtstück 13 beispielsweise durch chemisches Ätzen abgetragen. In die freigelegte Oberfläche der Schicht 10 wird beispielsweise mittels Elektronenstrahl das Gitter 20 eingeschrieben. Nach dem Aufbringen des P-Kontakts 310, beispielsweise durch Aufdampfen, wird die Deckschicht 17 aufgebracht. Der Kontakt 30 kann vor Beginn, während oder nach Beendigung des Verfahrens aufgebracht werden.

Wenn die dem Schichtstück 13 entsprechende Schicht eine Einfachschicht ist und der $P^+$-dotierte Bereich durch Diffusion erzeugt wird, so kann diese Diffusion vor oder nach dem Abtragen dieser Schicht vorgenommen werden.

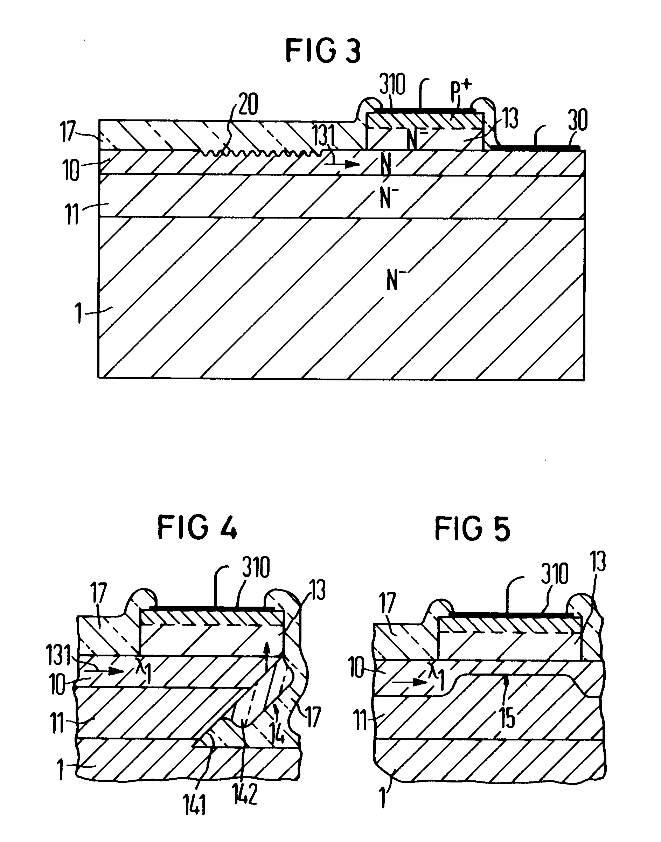

Die in der Fig.3 dargestellte modifizierte Ausführungsform des Moduls unterscheidet sich von dem Modul nach den Fig.1 und 2 lediglich dadurch, daß das Substrat 1 und die Schicht 11 semiisolierend sind und dadurch der N-Kontakt 30 nicht auf der den P-Kontakt 310 gegenüberliegenden Seite des Substrats 1, sondern auf der gleichen Seite wie der P-Kontakt 310 angeordnet ist.

Die Fig.4 zeigt ein bei dem Schichtstück 13 angeordnetes reflektierendes Element 14, das die am Schichtstück 13 vorbeigehende Strahlung in Richtung zum Schichtstück 13 reflektiert. Die Realisierung dieses reflektierenden Elementes kann so erfolgen, daß durch naßchemisches Ätzen oder durch Elektronenstrahlätzen eine Fläche 141 erzeugt wird, die sich quer über die Schicht 10 und schräg zur Richtung 131 erstreckt. Diese Fläche 141 kannn, wenn sie im richtigen Winkel angeordnet ist, Totalreflexion bewirken, und bildet dann bereits das reflektierende Element 14, das dann zweckmäßigerweise mit einer Schuchtschicht abgedeckt wird. Auf die Fläche 141 kann auch ein reflektierender Belag 142, beispielsweise eine dielektrische Vielfachschicht, aufgebracht werden. Zweckmäßig ist es, einen reflektierenden Belag 142 zu verwenden, der zusätzlich eine Filterwirkung derart aufweist, daß er für eine Strahlung mit störender Wellänge, die im Fall der Fig.4 die Wellenlänge $_2$ wäre, überflüssig ist. Diese störende Wellenlänge wird dann nicht in das Schichtstück 13 reflektiert. Ein solcher Belag kann ebenfalls durch eine Vielfachtschicht realisiert werden.

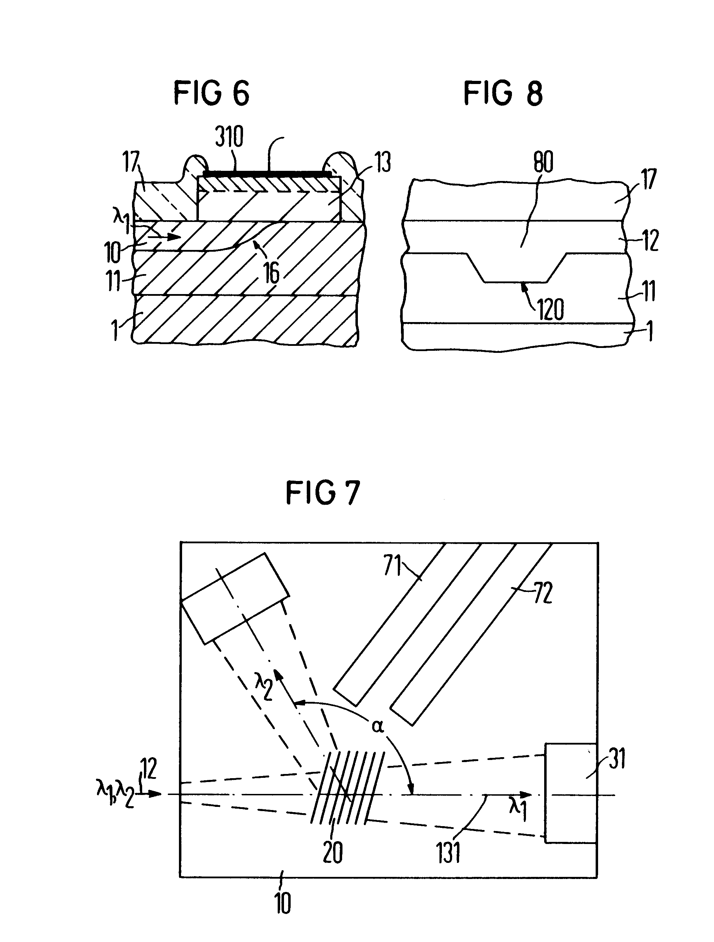

Die Fig.5 und 6 zeigen zwei Realisierungen von Verjüngungen des Schichtwellenleiter 10 im Bereich des Schichtstückes 13. Im Fall der Fig.5 erweitert sich der Schichtwellenleiter 10 nach der Verjüngung 15 wieder, während er im Fall der Fig.6 mit der Verjüngung 16 endet.

Die in der Fig.7 dargestellte Modifikation des Modulators nach Fig.1 unterscheidet sich von diesem im wesentlichen nur dadurch, daß die Furchen des Gitters 20 steiler als 45° zur Richtung 12 verlaufen, wodurch bewirkt wird, daß die Richtungen 131 und 132 nicht einen Winkel von 90°, sondern einen größeren Winkel $\alpha$ zwischen sich einschließen. Die Detektoren 31 und 32 sind dadurch weiter voneinander entfernt. Dadurch wird die Nebensprechdämpfung erhöht. Außerdem verläuft dazwischen den in den Richtungen 131 und 132 sich ausbreitenden Strahlungsanteilen und den Detektoren 31 und 32 eine Furche 71 und ein Erdungskontakt 72. Alle diese Maßnahmen tragen dazu bei, daß die Nebensprechdämpfung erhöht wird. Bei einem Kanalabstand von 10 bis 20 nm bei 1,55 $\mu$m kann eine Nebensprechdämpfung von mehr als 20 Dezibel, bezogen auf optische Leistung, erwartet werden. Vorausgesetzt ist dabei ein Gitter 20 mit einer Gitterlänge, das eine Spitzenreflexion für die reflektierte Wellenlänge $\lambda_2$ liefert, die größer als 0,99 ist.

Durch die in der Fig.8 in Stirnansicht gezeigte Verdickung 120 des Schichtwellenleiters 10 wird eine bessere Einkopplung der beispielsweise aus einer Monomode-Faser austretenden Strahlung in den Schichtwellenleiter 10 erreicht, weil diese Verdickung 120 dem Querschnitt der Faser, deren Achse durch den Punkt 80 und senkrecht zur Zeichenebene verläuft, besser angepaßt ist. Beispielsweise kann der Schichtwellenleiter im Bereich der Verdickung 120 doppelt so dick sein wie außerhalb. Die Kopplung zwischen der Monomode-Faser und dem Modul erfolgt zweckmäßigerweise über einen Fasertaper.

**Patentansprüche**

1. Monolithisch integrierter WDM-Demultiplexmodul, wobei auf einem gemeinsamen Substrat (1)
   - ein Schichtwellenleiter (10) zur Führung einer mehrere Wellenlängen ($\lambda_1$, $\lambda_2$) enthaltenden Strahlung,
   - ein wellenlängenselektierendes Element (20) zur Aufspaltung der im Schichtwellenleiter (10) geführten und in einer bestimmten Richtung (12) sich ausbreitenden Strahlung in untereinander verschiedene Wellenlängen ($\lambda_1$, $\lambda_2$) enthaltende und in verschiedenen Richtungen (131, 132) im Schichtwellenleiter (10) sich ausbreitende Strahlungsanteile, und
   - mehrere optisch an den Schichtwellenleiter (10) gekoppelte und jeweils einen der untereinander verschiedene Wellenlängen enthaltende und in verschiedenen Richtungen sich ausbreitenden Strahlungsanteile empfangende Fotodetektoren (31, 32) ausgebildet sind, insbesondere Moduln nach einem der vorhergehenden Ansprüche,
   dadurch **gekennzeichnet,**
   daß das wellenlängenselektierende Element (20) so ausgebildet ist, daß die verschiedenen Richtungen (131, 132), in denen sich zwei aufgespaltene benachbarte Strahlungsanteile im Schichtwellenleiter (10) ausbreiten, einen Winkel ($\alpha$) zwischen sich einschließen, der größer als 90° ist, und/oder daß zwischen benachbarten Strahlungsanteilen und Fotodetektoren (31, 32) eine Furche (71) und/oder ein Erdungskontakt (72) ausgebildet ist.

2. Modul nach Anspruch 1, dadurch **gekennzeichnet,** daß das wellenlängenselektierende Element (20), das so ausgebildet ist, daß die verschiedenen Richtungen (131, 132), in denen sich zwei benachbarte aufgespaltene Strahlungsanteile im Schichtwellenleiter (10) ausbreiten, einen Winkel ($\alpha$) zwischen sich einschließen, der größer als 90° ist, aus einem Gitter besteht, dessen Furchen steiler als 45° zu der bestimmten Richtung (12) verlaufen, in der sich auf das Gitter treffende Strahlung ausbreitet.

3. Monolithisch integrierter WDM-Demultiplexmodul, wobei auf einem gemeinsamen Substrat (1)
   - ein Schichtwellenleiter (10) zur Führung einer mehrere Wellenlängen ($\lambda_1$, $\lambda_2$) enthaltenden Strahlung,
   - ein wellenlängenselektierendes Element (20) zur Aufspaltung der im Schichtwellenleiter (10) geführten und in einer bestimmten Richtung (12) sich ausbreitenden Strahlung in untereinander verschiedene Wellenlängen ($\lambda_1$, $\lambda_2$) enthaltende und in verschiedenen Richtungen (131, 132) im Schichtwellenleiter (10) sich ausbreitende Strahlungsanteile, und
   - mehrere optisch an den Schichtwellenleiter (10) gekoppelte und jeweils einen der untereinander verschiedene Wellenlängen enthaltende und in verschiedenen Richtungen sich ausbreitenden Strahlungsanteile empfangende Fotodetektoren (31, 32) ausgebildet sind, insbesondere Module nach einem der vorhergehenden Ansprüche,
   dadurch **gekennzeichnet,**
   daß der Schichtwellenleiter (10) eine Verdickung (120) aufweist, die einen Streifenwellenleiter definiert, über den Strahlung in den Schichtwellenleiter (10) einkoppelbar ist.

4. Modul nach Anspruch 3, dadurch **gekennzeichnet,** daß die Verdickung (120) des Schichtwellenleiters durch einen parallel zum Schichtwellenleiter (10) verlaufenden vergrabenen Streifenwellenleiter realisiert ist, der sich in das Substrat (1) erstreckt.

# FIG 1

# FIG 2

# FIG 3

# FIG 4

# FIG 5

8

# FIG 6

310

17    13

$\lambda_1$

10

11

16

1

# FIG 8

80

17

12

11

120

1

# FIG 7

71

72

$\lambda_2$

$\alpha$

$\lambda_1 \lambda_2$    12

31

$\lambda_1$

20    131

10

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-0 006 052 (THOMSON-CSF) <br> * Zusammenfassung; Figuren 1, 8 * <br> – – – | 1,2,3 | G 02 B 6/12 |
| A | ELECTRONICS LETTERS. vol. 21, no. 21, Oktober 1985, ENAGE GB Seiten 953 - 954; R.A.SOREF ET AL.: "SINGLE-CRYSTAL SILICON:A NEW MATERIAL FOR 1,3 AND 1,6 MICROMETER INTEGRATED-OPTICAL COMPONENTS " <br> * Figur 3 * <br> – – – – – | 4 | |

| RECHERCHIERTE SACHGEBIETE (Int. Cl.5) |
|---|
| G 02 B |

Der vorliegende Recherchenbericht wurde für alle Patentansprüche erstellt

| Recherchenort | Abschlußdatum der Recherche | Prüfer |
|---|---|---|
| Berlin | 17 Oktober 91 | FUCHS R |